# EUROPEAN PATENT APPLICATION

(11) **EP 4 661 605 A1**
(43) Date of publication of application: **10.12.2025**
(21) Application number: 24863810.8
(22) Date of filing: 25.04.2024
(51) Int. Cl.: H05K 1/18, H05K 1/02, H05K 3/46

(54) **METHOD FOR MANUFACTURING MULTILAYER SUBSTRATE**

(71) Applicant: Future Technology Co., Ltd., Tokyo 171-0014 (JP)
(72) Inventor: HAYASHI, Koji, Toshima-ku, Tokyo 1710014 (JP); MURAMATSU, Yoshihito, Minato-ku, Tokyo 1050003 (JP)
(74) Representative: Gill Jennings & Every LLP
(86) International application number: PCT/JP2024/016283
(87) International publication number: WO 2025/224934

(57) **Abstract**

Provided is a multilayer substrate manufacturing technology that enables manufacturing a multilayer substrate at low cost. First, a cover sheet (2) is superposed on a base material sheet (1) having the same shape and size as a shape and a size of the cover sheet. Wiring (11) is provided on one surface of the base material sheet (1). A hole (21) is made in the cover sheet (2) at a position through which an electronic component is to be mounted to the base material sheet (1) later. The superposed base material sheet (1) and cover sheet (2) are then folded so that the hole (21) is exposed to an outside. The electronic component is inserted into the hole (21), and the electronic component is mounted in continuity with the wiring (11) of the base material sheet (1).

## Description

### Technical Field

The present invention relates to a method of manufacturing a multilayer substrate.

### Background Art

Various electronic devices have a built-in substrate that has wiring forming a circuit and includes a variety of electronic components mounted thereto. Among substrates, there exist what are called multilayer substrates.

A multilayer substrate is formed by laminating a plurality of substrates. Each substrate includes a plate-like or sheetlike base material, and wiring is provided on at least one surface of the base material. A multilayer substrate, which has the structure in which a plurality of substrates each having wiring are laminated, has a large thickness as a matter of course, but is widely and practically used because the multilayer substrate can contain more circuits and electronic components in the same area as compared to a single-layer substrate, and hence can demonstrate a high degree of integration.

The circuits in the respective substrates contained in the multilayer substrate are generally required to be brought into electrical continuity with each other.

For this reason, a hole, which collectively penetrates the respective substrates contained in the multilayer substrate in a superposed state and is called "through-hole," is generally drilled in the multilayer substrate. In general, a metal layer is provided on an inner peripheral surface of the through-hole by, for example, plating with conductive metal, and pieces of the wiring in the respective substrates are brought into continuity with the metal layer. Thus, the pieces of the wiring in the respective substrates contained in the multilayer substrate are brought into electrical continuity with each other through the metal layer in the through-hole. For example, pieces of the wiring provided on both surfaces of a single substrate are brought into electrical continuity with each other through the metal layer in the through-hole.

Alternatively, pieces of the wiring provided on both surfaces of a single substrate or provided on any surfaces of a plurality of substrates are connected together through a conductive connecting wire outside the substrate, and thus pieces of the wiring located apart from each other can be brought into electrical continuity with each other. Such technology is also in practical use.

### Summary of Invention

### Technical Problem

The multilayer substrate is as described above, but there is room for improvement.

A related-art multilayer substrate has a through-hole or a connecting wire outside the substrate as described above.

When the through-hole is present, it is required to perform a step of making a hole in the substrate in order to form the through-hole, and a step of forming a metal layer on the inner peripheral surface of the through-hole. This increases cost for manufacturing a multilayer substrate.

Further, as described above, the through-hole is brought into electrical continuity with the wiring of the respective substrates contained in the multilayer substrate, and hence it is required to accurately position the wiring with respect to a base material in each substrate, and to accurately perform relative positioning of the plurality of substrates to be laminated in laminating the plurality of substrates. As a matter of course, the two types of positioning accuracy required for the reason as described above are technically feasible. However, achievement of the two types of positioning accuracy takes effort, which tends to cause an increase in cost.

In addition, in related-art steps of manufacturing a multilayer substrate, a plurality of substrates to be laminated are separately manufactured, and then the plurality of substrates separately manufactured are superposed on each other. Alternatively, in some cases, a cover sheet and copper foil are laminated on top and bottom of a substrate to form circuits on upper and lower surfaces of the substrate, and the procedure is repeated to sequentially increase the number of layers. Here, in a case of manufacturing each substrate, common steps such as forming a circuit on the copper foil bonded to the base material and plating with gold are generally executed for each substrate. Thus, the cost tends to increase due to the repeated execution of the common steps in each substrate. The same holds true for a case in which a cover sheet and copper foil are laminated on the top and bottom of the substrate.

Even in a case of providing the connecting wire outside the substrate, the cost for manufacturing a multilayer substrate is inflated by performing the step of providing the connecting wire. In addition, the circumstance remains unchanged in that the cost tends to increase due to the repeated execution of the common steps in each substrate.

The invention of the present application has a main subject to provide a multilayer substrate manufacturing technology that enables manufacturing a multilayer substrate at low cost.

### Solution to Problem

The invention of the present application for solving the above-mentioned problem is as follows.

According to the invention of the present application, there is provided a method of manufacturing a multilayer substrate, including: a superposing step of superposing a cover sheet on a front surface of a base material sheet under a state in which a contour of the base material sheet and a contour of the cover sheet match each other, the base material sheet being provided with conductive wiring on the front surface in appropriate arrangement, and being a rectangular sheet that is made of a thermoplastic resin and has insulating properties, the cover sheet having at least one hole formed at a position at which an electronic component is to be arranged later, and being a sheet that is made of a thermoplastic resin, has insulating properties, and has virtually the same shape and size as a shape and a size of the base material sheet; a folding step of folding the superposed base material sheet and cover sheet so that the at least one hole is exposed to an outside; a fixing step of fixing the base material sheet and the cover sheet adjacent to each other by heating the folded base material sheet and cover sheet to melt at least a part of the cover sheet, and then cooling and curing the base material sheet and the cover sheet; and an electronic component mounting step of securing an electronic component, which is inserted into the at least one hole, to the base material sheet seen through the at least one hole under a state in which the electronic component is held in electrical continuity with the wiring on the front surface of the base material sheet seen through the at least one hole.

In this method of manufacturing a multilayer substrate, as described above, the superposing step, the folding step, the fixing step, and the electronic component mounting step are performed in the stated order.

In the superposing step, the cover sheet is superposed on the front surface of the base material sheet. The base material sheet is a rectangular sheet made of a thermoplastic resin and having insulating properties. The wiring is provided on the front surface of the base material sheet. The wiring is not provided on the cover sheet, but is provided only on the base material sheet. Further, the wiring is provided only on one surface of the base material sheet. Of both surfaces of the base material sheet, a surface on which the wiring is provided is the front surface. The wiring is conductive, and is generally made of conductive metal. There are no restrictions on a method of providing the wiring on the base material sheet, and the wiring can be provided on the front surface of the base material sheet by publicly-known or well-known methods. For example, a subtractive method in which copper foil is bonded to an entire front surface of a base material sheet with an adhesive, and an unnecessary portion is removed by chemical etching while leaving the wiring portion, or an additive method in which the wiring is plated (in most cases, electroless plating and electrolytic plating) on the front surface of the base material sheet can be used as a technology of providing the wiring on the base material sheet. The cover sheet is a rectangular sheet that has virtually the same shape and size as those of the base material sheet. The cover sheet is made of a thermoplastic resin, and has insulating properties. At least one hole is formed in the cover sheet. The hole formed in the cover sheet is formed at a position corresponding to a position at which the electronic component is to be arranged on the base material sheet later. The cover sheet is superposed on the base material sheet so that the contour of the cover sheet matches that of the base material sheet.

In the folding step to be performed subsequently, the base material sheet and the cover sheet in the superposed state are folded together. The folding is performed at least once. The folding may be mountain-folding or valley-folding, or may be a combination of mountain-folding and valley-folding. After the folding step is performed, the above-mentioned hole formed in the cover sheet is brought into a state of being exposed to the outside. With the base material sheet being folded together with the cover sheet, at least a part of the base material sheet is at least double laminated with the rest of the base material sheet, though the cover sheet may be interposed therebetween. Thus, the wiring provided on the front surface of the base material sheet is also at least double laminated.

In the fixing step to be performed subsequently, the base material sheet and the cover sheet that are adjacent to each other in the folded state are fixed together. In a case of performing such fixing, the folded base material sheet and cover sheet are heated to melt at least a part of the cover sheet, and then are cooled and cured, to thereby fix the adjacent base material sheet and cover sheet together by using the molten cover sheet as, for example, an adhesive. The term "cooling" as used in the present application also refers to a case in which, without requiring active processing to cool down, the base material sheet and the cover sheet after heating are left in an atmosphere at a temperature (for example, room temperature) lower than a melting point of the thermoplastic resin that forms the cover sheet. It is also permissible to melt not only the cover sheet but also a part of the base material sheet, and then cool and cure the sheets. Further, in the fixing step, of the superposed base material sheet and cover sheet, adjacent portions of the cover sheet may be fixed to each other. In any case, with the fixing step being performed, the folded base material sheet and cover sheet are united, and the relative positional relationship as a whole is basically settled.

Then, the electronic component mounting step of mounting the electronic component to the base material sheet is performed. As described above, after the folding step is finished, the hole formed in the cover sheet is exposed to the outside. The hole formed in the cover sheet corresponds to the position at which the electronic component is to be mounted. Under a state in which the electronic component is inserted through the hole and held in electrical continuity with the wiring on the front surface of the base material sheet seen through the hole, the electronic component is secured to the base material sheet seen through the hole. It goes without saying that the wiring provided on the base material sheet is designed so as to form an electric circuit in combination with at least one planned electronic component when the electronic component is mounted to the base material sheet.

In this manner, the multilayer substrate is manufactured.

The electronic component to be used in manufacturing a multilayer substrate includes, for example, integrated circuit (IC) chips, ball grid arrays (BGAs), chip size packages (CSPs), resistors, and capacitors, and is not different from electronic components to be mounted to general substrates.

In the multilayer substrate manufactured by the method of manufacturing a multilayer substrate of the invention of the present application described above, when at least one planned electronic component is mounted to the base material sheet, an electric circuit is formed in combination with the electronic component, and hence a through-hole are not required and a connecting wire made outside the substrate are not required. Therefore, a step of producing the through-hole and the connecting wire can be omitted, and thus it is possible to reduce cost in a case of manufacturing a multilayer substrate.

Further, in the method of manufacturing a multilayer substrate described above, multilayer substrates with various structures can be obtained depending on how the superposed base material sheet and cover sheet are folded in the folding step.

In addition, in the multilayer substrate manufactured by the method of manufacturing a multilayer substrate described above, the front surface of the base material sheet is covered with the cover sheet except for the portion in which the hole is made. Thus, the wiring is protected by the cover sheet, and hence the wiring is less liable to be broken.

As described above, the base material sheet and the cover sheet that are to be used in the invention of the present application are each made of a thermoplastic resin.

The thermoplastic resin for forming the base material sheet and the thermoplastic resin for forming the cover sheet may be or may not be the same.

Examples of materials that can be used as the thermoplastic resins for forming the base material sheet and the cover sheet include liquid crystal polymer (LCP). Other usable materials include, for example, polyphenylene sulfide (PPE), polyether ether ketone (PEEK), and fluororesin (FR), but other thermoplastic resins can also be used.

Liquid crystal polymer is publicly known as a material and known as a material with low loss and excellent high-frequency characteristics, and hence is suitable for use as a material for the base material sheet and the cover sheet.

It is required that a thickness of the base material sheet and a thickness of the cover sheet be set small enough to allow the folding step to be performed under a state in which the both sheets are superposed on each other. Meanwhile, it is preferred that the thickness of the cover sheet exceed a thickness of the wiring formed on the base material sheet. As described above, the cover sheet protects the wiring after the fixing step. However, when the thickness of the cover sheet is smaller than the thickness of the wiring, the wiring is not sufficiently protected, and the wiring portion is not covered with the cover sheet, with the result that the top of the wiring may be left exposed. Further, even when the wiring can be protected by covering the wiring with the cover sheet, the thickness of the wiring may appear as a convexity on the cover sheet, and hence flatness of the multilayer substrate may not be maintained. However, when such a case arises, there is a fear in that defects such as poor junction may occur when the electronic component is finally mounted on a surface with poor flatness. Further, the thickness of the cover sheet may be smaller than the thickness of the base material sheet. When the thickness of the cover sheet is smaller than that of the base material sheet, rigidity during the folding step is reduced to improve folding performance, and this leads to reductions in processing cost and material cost.

As described above, the base material sheet to be used in the invention of the present application is rectangular, and the cover sheet to be used in the invention of the present application is rectangular and has the same shape and size as those of the base material sheet.

The base material sheet may be square. As described above, the base material sheet and the cover sheet are folded by being folded in the mutually superposed state. When the base material sheet and the cover sheet are square, various folding methods used in origami, which is a traditional Japanese culture, can be applied. For example, there can be obtained a multilayer substrate that has a regular shape such as a rectangle or a triangle, and has, in all portions in a thickness direction, the same total number of plies of the base material sheet and the cover sheet present in the all portions.

For Example, after the electronic component mounting step is finished, the base material sheet and the cover sheet may each have a square shape or a right-angled isosceles triangular shape. Such a regular shape is convenient when the multilayer substrate is incorporated into a final product. Two right-angled isosceles triangular multilayer substrates can also be combined to form a square substrate.

According to the invention of the present application, the folding step may be performed so that, after the electronic component mounting step is finished, all portions of the base material sheet and the cover sheet are virtually parallel to each other except for folded portions of the base material sheet and the cover sheet.

In the multilayer substrate manufactured as described above, the base material sheet and the cover sheet are laminated virtually in parallel to each other except for the folded portions, and have a plate-like shape as a whole. The plate-like multilayer substrate has the same shape as those of many related-art multilayer or single-layer substrates, and is expected to have many applications.

Meanwhile, after the electronic component mounting step is finished, portions of the base material sheet and the cover sheet may be brought into a state of being non-parallel to other portions of the base material sheet and the cover sheet. The multilayer substrate in this case does not have a plate-like shape, but may have a three-dimensional shape. Depending on a final product to which the substrate is to be mounted, a multilayer substrate with a three-dimensional shape may be convenient.

It can be said that it is one of advantages of the method of manufacturing a multilayer substrate according to the invention of the present application that multilayer substrates with such various shapes can be obtained by the similar manufacturing method.

The folding step may also be performed so that, after the electronic component mounting step is finished, the number of plies of the superposed base material sheet and cover sheet in a certain region other than the folded portions is different from the number of plies of the superposed base material sheet and cover sheet in another region.

For example, it is assumed that a plate-like multilayer substrate is manufactured by the method of manufacturing a multilayer substrate. Then, it is assumed that, in a certain region of the completed multilayer substrate, the base material sheet and the cover sheet are superposed so as to each have four plies, and in another region, the base material sheet and the cover sheet are superposed so as to each have eight plies. Then, naturally, the thickness of the above-mentioned another region of the multilayer substrate is larger than that of the above-mentioned certain region of the multilayer substrate. It can be said that it is one of advantages of the method of manufacturing a multilayer substrate according to the invention of the present application that such a multilayer substrate with different thicknesses in different portions can be obtained by the same manufacturing method. It is possible to manufacture a substrate with different thicknesses in different portions, and hence there is an advantage that a portion of the substrate having a smaller thickness uses a reduced amount of the base material, thereby being capable of contributing to reductions in material cost and processing cost.

As described above, in the fixing step, the superposed base material sheet and cover sheet are heated. In the fixing step, the superposed base material sheet and cover sheet may be heated while pressure is applied thereto. In this manner, the base material sheet and the cover sheet, or the cover sheet and the cover sheet can be fixed to each other evenly and firmly.

The fixing step may be performed by heating (or heating and pressing) the entire base material sheet and cover sheet at a time after the folding step is finished. Alternatively, the fixing step may be performed by separately heating (or heating and pressing) parts of the base material sheet and the cover sheet and other parts of the base material sheet and the cover sheet a plurality of times after the folding step is finished. When the completed multilayer substrate has a three-dimensional shape, the fixing step is often performed in the latter way.

In the method of manufacturing a multilayer substrate of the invention of the present application, before the superposing step, a wiring step of providing the wiring on the front surface of the base material sheet may be performed. As already described above, there are no particular restrictions on the technology that can be used for providing the wiring on the front surface of the base material sheet in the wiring step, and any publicly-known or well-known technology can be used.

The wiring may be provided so that a width of the wiring at a portion at which the base material sheet will be folded later is larger than a width of the wiring at portions on both sides of the folded portion in a length direction of the wiring. In the method of manufacturing a multilayer substrate of the invention of the present application, the wiring is folded together with the base material sheet. Accordingly, there are some risks in that the wiring is broken. When the width of the wiring at the portion at which the base material sheet is folded is larger than the widths of the portions on both sides of the folded portion in the length direction thereof, such a configuration helps to prevent breakage of the wiring to be folded together with the base material sheet.

When the wiring step is performed before the superposing step, the wiring can be produced so that the width of the wiring at the portion at which the base material sheet is folded is larger than the widths of the portions on both sides of the folded portion in the length direction.

### Brief Description of Drawings

FIG. 1 is a view for illustrating a base material sheet to be used in one embodiment of the invention of the present application as seen from a front side thereof;
FIG. 2 is a view for illustrating the base material sheet provided with wiring as seen from the front side;
FIG. 3 is an enlarged view for illustrating a region near the reference symbol X in FIG. 2;
FIG. 4 is a view for illustrating a cover sheet as seen from a front side thereof;
FIG. 5 is a view for illustrating the base material sheet and the cover sheet as seen from the front side at the time when a superposing step is finished in one embodiment;
FIGS. 6 are views for illustrating how a folding step is performed in one embodiment;
FIGS. 7 are views for illustrating a completed multilayer substrate after an electronic component mounting step is finished in one embodiment;
FIG. 8(A) to FIG. 8(D) are views for illustrating how a folding step is performed in Modification Example 1, and FIG. 8(E) is a side view for illustrating the base material sheet and the cover sheet that are illustrated in FIG. 8(D);
FIG. 9 is a view for illustrating the base material sheet and the cover sheet as seen from the front side at the time when a superposing step is finished in Modification Example 2;
FIGS. 10 are views for illustrating how the folding step is performed in Modification Example 2;
FIGS. 11 are views for illustrating a completed multilayer substrate after the electronic component mounting step is finished in Modification Example 2;
FIG. 12 is a view for illustrating the base material sheet and the cover sheet as seen from the front side at the time when the superposing step is finished in Modification Example 3;
FIGS. 13 are views for illustrating how the folding step is performed in Modification Example 3;
FIGS. 14 are views for illustrating a completed multilayer substrate after the electronic component mounting step is finished in Modification Example 3;
FIG. 15 is a view for illustrating the base material sheet and the cover sheet as seen from the front side at the time when the superposing step is finished in Modification Example 4;
FIGS. 16 are views for illustrating how the folding step is performed in Modification Example 4; and
FIG. 17 is a perspective view for illustrating a completed multilayer substrate after the electronic component mounting step is finished in Modification Example 4.

### Description of Embodiments

Now, with reference to the drawings, one embodiment of the present invention and modification examples thereof are described.

In this embodiment, a method of manufacturing a multilayer substrate is described. A multilayer substrate is manufactured by performing each step as described below.

The multilayer substrate is manufactured using a base material sheet, a cover sheet, and electronic components as materials.

First, the base material sheet is described.

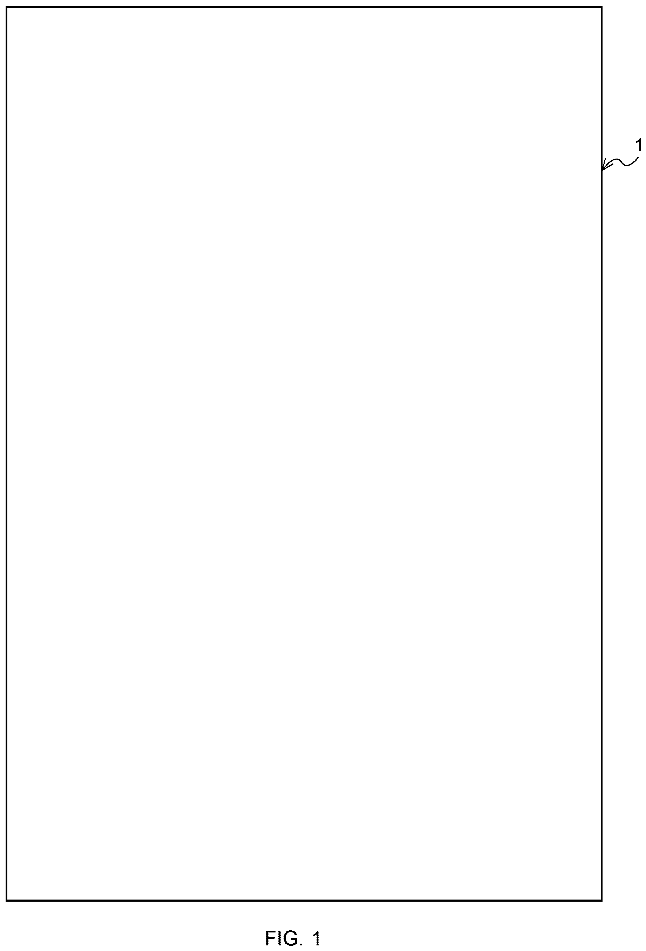

FIG. 1 shows a state of a base material sheet 1 as seen from a front surface side thereof. Wiring to be described later has not yet been provided on the base material sheet 1.

The base material sheet 1 is rectangular. The base material sheet 1 is square in some cases as described later, but is not square in the example illustrated in FIG. 1.

The base material sheet 1 is made of a thermoplastic resin, and has insulating properties. Examples of the thermoplastic resin that forms the base material sheet 1 can include liquid crystal polymer (LCP), polyphenylene sulfide (PPE), polyether ether ketone (PEEK), and fluororesin (FR). In this embodiment, liquid crystal polymer (LCP) is selected as the thermoplastic resin that forms the base material sheet 1, though not limited thereto.

A thickness of the base material sheet 1 can be appropriately selected within such a range that the base material sheet 1 can be folded together with the cover sheet as described later. The thickness can be set to, for example, from 20 µm to 200 µm, preferably from 25 µm to 100 µm.

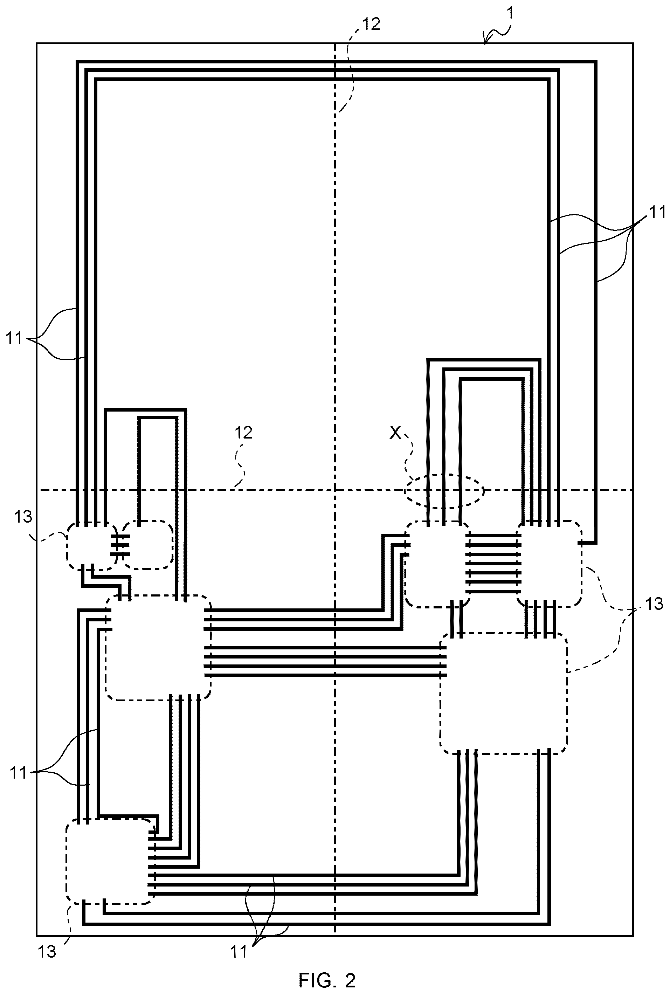

In this embodiment, wiring 11 is provided on the base material sheet 1 as described above (FIG. 2). The chain double-dashed lines denoted by the reference symbol 12 in FIG. 2 are folding lines that each indicate a portion at which the base material sheet 1 is to be folded later.

The wiring 11 is provided only on the front surface of the base material sheet 1. A surface of the base material sheet 1 on which the wiring 11 is provided is the front surface of the base material sheet 1.

The wiring 11 is conductive, and is generally made of conductive metal. Although a material for the wiring 11 is not limited thereto, in this embodiment, the wiring 11 is made of conductive metal.

There are no particular restrictions on the technology that can be used for providing the wiring 11 on the base material sheet 1, and any publicly-known or well-known technology can be used. For example, the wiring 11 can be provided on the front surface of the base material sheet 1 by a subtractive method in which copper foil is bonded to an entire front surface of a base material sheet with an adhesive, a wiring portion is covered with a mask, an unnecessary portion (portion of the copper foil not covered with the mask) is then removed by chemical etching, and finally the mask is removed to leave the copper foil that has been covered with the mask as the wiring 11 on the front surface of the base material sheet 1, or by an additive method in which a metal plating layer is provided in a region in which no mask exists by plating (for example, electroless plating and electrolytic plating) after providing a mask on the front surface of the base material sheet 1 so that only a portion corresponding to the wiring 11 is exposed, and then the mask is removed to obtain the wiring 11 on the base material sheet 1. The wiring 11 can be collectively provided by executing a step of performing wiring on the base material sheet 1, for example, by performing the subtractive method or the additive method once. Although not limited thereto, such technology is adopted in this embodiment.

In FIG. 2, a position enclosed by the dashed line denoted by the reference symbol 13 is a planned position at which an electronic component is to be mounted later. The reason why a size of a planned position 13 is not uniform is that the planned position 13 is designed to adapted to a size of the electronic component planned to be mounted thereto.

Further, it is not always required that the wiring 11 be provided on the base material sheet 1 illustrated in FIG. 1. For example, it is naturally possible to adopt the following method. Specifically, on a base material sheet having a size larger than that of the base material sheet 1 illustrated in FIG. 1 (for example, a base material sheet that is 10 times larger in length and width than the base material sheet 1 illustrated in FIG. 1), 10×10=100 pieces of the wiring 11 are provided, and then the base material sheet is cut into 10 pieces each in length and width to obtain 100 identical base material sheets 1 with the wiring 11 illustrated in FIG. 2 at a time. Such a method of producing the wiring 11 enables efficient mass production of multilayer substrates. In this case as well, 10×10=100 pieces of the wiring provided on the large-sized base material sheet can be provided collectively by executing the step of performing wiring on the large-sized base material sheet once. In this manner, cost reduction in manufacturing the base material sheet 1 can be achieved.

The wiring 11 may be or may not be formed to have the same width in all portions. It is also possible to set an appropriate width for each piece of the linear wiring 11 connecting electronic components to each other, which are mounted to the base material sheet 1 as described later. For example, a width of at least one piece of the linear wiring 11 may be different from a width of another piece of the linear wiring 11.

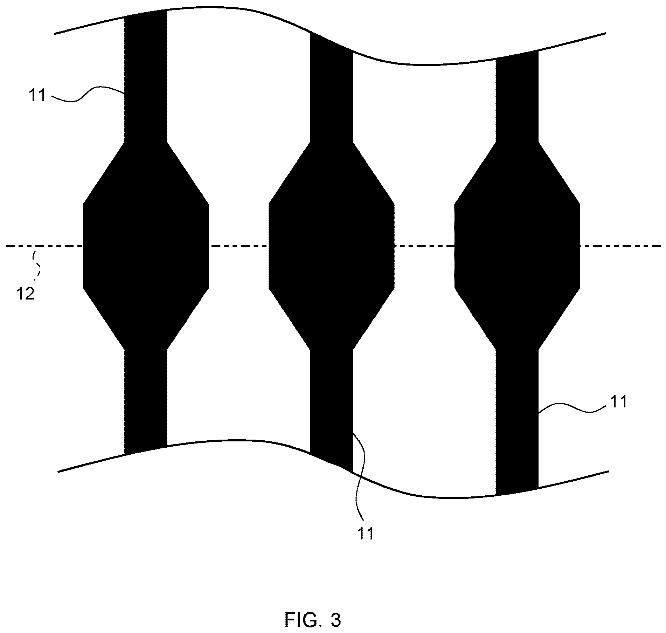

Further, it is not required that a width of one piece of the linear wiring 11 be constant over an entire length of the one piece of the linear wiring 11. As can be seen from FIG. 2, the linear wiring 11 extends astride the folding lines 12 in some cases. In such a case, the width of the wiring 11 at a straddle position at which the wiring 11 extends astride the folding line 12 may be larger than the width of the wiring 11 on both sides of the straddle position in a length direction thereof. An example of this case is illustrated in FIG. 3. FIG. 3 is an enlarged view for illustrating a region indicated by the dashed line X in FIG. 2. As illustrated in FIG. 3, a straddle portion of the wiring 11 extending astride the folding line 12 is wider than portions of the wiring 11 on both sides or front and back sides of the straddle portion in the length direction of the wiring 11. Although the present invention is not limited thereto, regarding every piece of the wiring 11 extending astride the folding line 12 in this embodiment, the straddle portion of the wiring 11 extending astride the folding line 12 is wider than the portions of the wiring 11 on both sides or front and back sides of the straddle portion in the length direction thereof. In this embodiment, when the wiring 11 is provided on the base material sheet 1, the straddle portion of the wiring 11 extending astride the folding line 12 is wider than the portions of the wiring 11 on both sides or front and back sides of the straddle portion in the length direction thereof. As a matter of course, FIG. 3 is an example. In FIG. 3, the width of the straddle portion of the wiring 11 extending astride the folding line 12 is linearly larger than those of the portions of the wiring 11 on both sides or front and back sides of the straddle portion in the length direction thereof. However, for example, the width of the straddle portion of the wiring 11 extending astride the folding line 12 may be larger in a curved manner than those of the portions of the wiring 11 on both sides or front and back sides of the straddle portion in the length direction thereof, or may be larger in a crank-shaped manner from a certain position.

Next, the cover sheet is described.

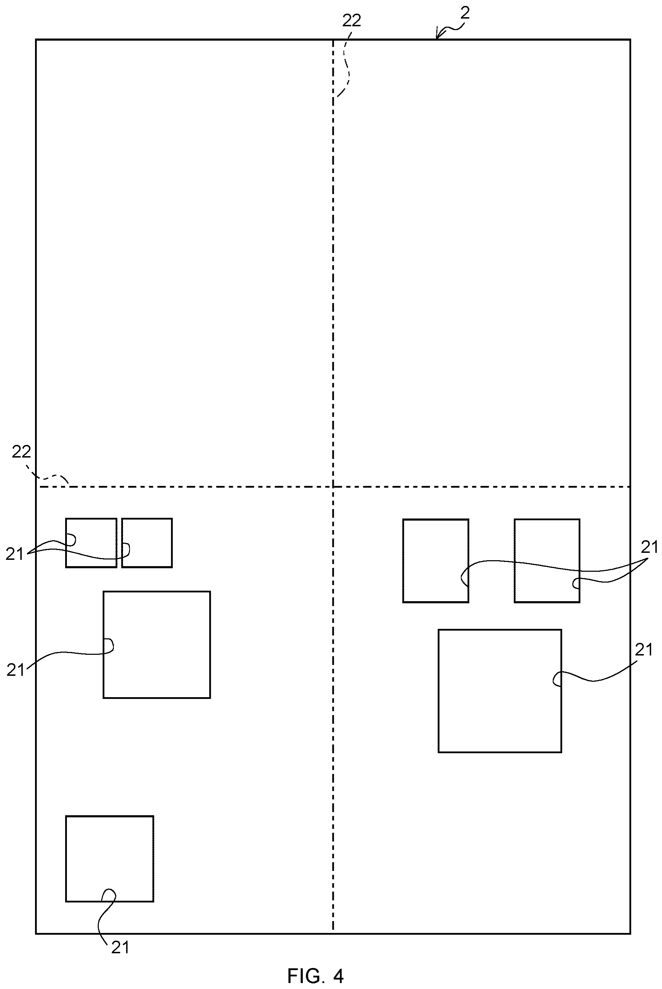

FIG. 4 is a view for illustrating the cover sheet 2 as seen from a front side thereof. The front side of the cover sheet 2 is a side that does not face the base material sheet 1 when the cover sheet 2 is superposed on the base material sheet 1 later.

The cover sheet 2 is a rectangular sheet that has virtually the same shape and size as those of the base material sheet 1. No wiring is provided on the cover sheet 2.

The cover sheet 2 is made of a thermoplastic resin, and has insulating properties. Examples of the thermoplastic resin that forms the cover sheet 2 can include liquid crystal polymer (LCP), polyphenylene sulfide (PPE), polyether ether ketone (PEEK), and fluororesin (FR).

In this embodiment, liquid crystal polymer (LCP) is selected as the thermoplastic resin that forms the cover sheet 2, though not limited thereto. The thermoplastic resin for forming the cover sheet 2 and the thermoplastic resin for forming the base material sheet 1 may be or may not be the same. Regardless of whether the materials of the base material sheet 1 and the cover sheet 2 are the same or different, required processing can be performed on the base material sheet 1 and the cover sheet 2 by adjusting processing conditions, such as a temperature and heating time during heating in a fixing step to be described later, and pressure to be applied as required.

A thickness of the cover sheet 2 can be appropriately selected within such a range that the cover sheet 2 can be folded together with the base material sheet 1 as described later. The thickness can be, for example, from 20 µm to 200 µm, preferably from 25 µm to 100 µm.

The thickness of the base material sheet 1 and the thickness of the cover sheet 2 may be or may not be the same. As already described above, it is required that the thickness of the base material sheet 1 and the thickness of the cover sheet 2 be set small enough to allow a folding step to be performed under a state in which the both sheets are superposed on each other.

Meanwhile, it is preferred that the thickness of the cover sheet 2 exceed the thickness of the wiring 11 formed on the base material sheet 1. When the thickness of the cover sheet 2 is smaller than the thickness of the wiring 11, there may be cases in which the cover sheet 2 does not cover the wiring 11 satisfactorily after the fixing step to be described later is performed. Further, when the thickness of the cover sheet 2 is smaller than that of the wiring 11, even when the cover sheet 2 can cover the wiring 11 after the fixing step, the thickness of the wiring 11 may appear as a convexity on the surface of the cover sheet 2 covering the wiring 11 (surface on a side on which the cover sheet 2 is not held in abutment against the base material sheet 1). When the thickness of the wiring 11 appears on the surface of the cover sheet 2 as a convexity, there is a fear in that defects such as poor junction may occur when electronic components are mounted on a surface with poor flatness. However, such defects are less liable to occur when the thickness of the cover sheet 2 is set larger than the thickness of the wiring 11.

Further, the thickness of the cover sheet 2 may be smaller than the thickness of the base material sheet 1. When the thickness of the cover sheet 2 is set smaller than that of the base material sheet 1, rigidity during the folding step to be described later is reduced to improve folding performance, and this leads to reductions in processing cost and material cost.

At least one hole 21 is formed in the cover sheet 2. The hole 21 is formed at a position corresponding to a position at which an electronic component is to be arranged on the base material sheet 1 later, that is, the planned position 13. The reason why the holes 21 are not uniformly sized is that each of the holes 21 is designed to adapted to a size of the electronic component planned to be mounted thereto. In this embodiment, seven holes 21 are formed in the cover sheet 2, though not limited thereto.

The chain double-dashed lines denoted by the reference symbol 22 in FIG. 4 are folding lines that each indicate a portion at which the cover sheet 2 is to be folded together with the base material sheet 1 later. The base material sheet 1 and the cover sheet 2 superposed on each other are folded together, and hence the folding line 12 of the base material sheet 1 and the folding line 22 of the cover sheet 2 are located at corresponding positions.

After preparing the base material sheet 1 and the cover sheet 2 that have been described above, a superposing step is first performed.

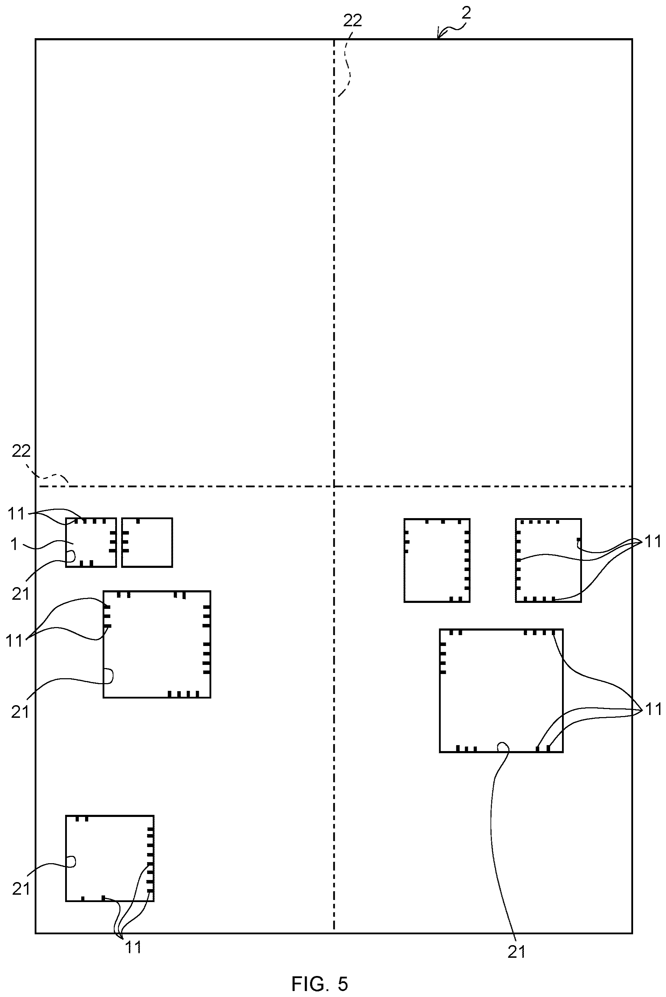

In the superposing step, the cover sheet 2 is superposed on the front surface of the base material sheet 1 so that contours of the two sheets match each other (FIG. 5). Thus, each of the holes 21 in the cover sheet 2 matches the planned position 13 in the base material sheet 1. The wiring 11 is seen inside a periphery in each of the holes 21.

Next, the folding step is performed.

In the folding step, the base material sheet 1 and the cover sheet 2 in the superposed state are folded together. The folding is performed along the folding lines 12 of the base material sheet 1 and the folding lines 22 of the cover sheet 2, which overlap each other. The folding is performed at least once. The folding may be mountain-folding or valley-folding, or may be a combination of mountain-folding and valley-folding. However, after the folding step is performed, the above-mentioned holes 21 formed in the cover sheet 2 are brought into a state of being exposed to the outside. The phrase "the holes 21 are exposed to the outside" means that the holes 21 are not covered with the base material sheet 1 or the cover sheet 2.

After performing the superposing step and before performing the folding step, a temporary fixing step of temporarily fixing the base material sheet 1 and the cover sheet 2 may be performed in order to prevent the contours of the superposed base material sheet 1 and cover sheet 2 from being misaligned at the time when the folding step is performed. Although not necessarily limited thereto, such a configuration is adopted in this embodiment. Temporary fixing can be performed by bonding, with an adhesive, parts (for example, four corners) of the portions of the base material sheet 1 and cover sheet 2 that are held in abutment against each other. However, there are no restrictions on the temporary fixing method. There may be used a pin lamination method, which is used in a general multilayer substrate manufacturing method, and in which substrates having holes made therein are laminated, and pins are inserted through holes formed in the respective substrates, thereby positioning the respective substrates. Alternatively, temporary fixing may be performed through use of a temporary fixing jig (clip, or the like) that clamps the base material sheet 1 and the cover sheet 2 together.

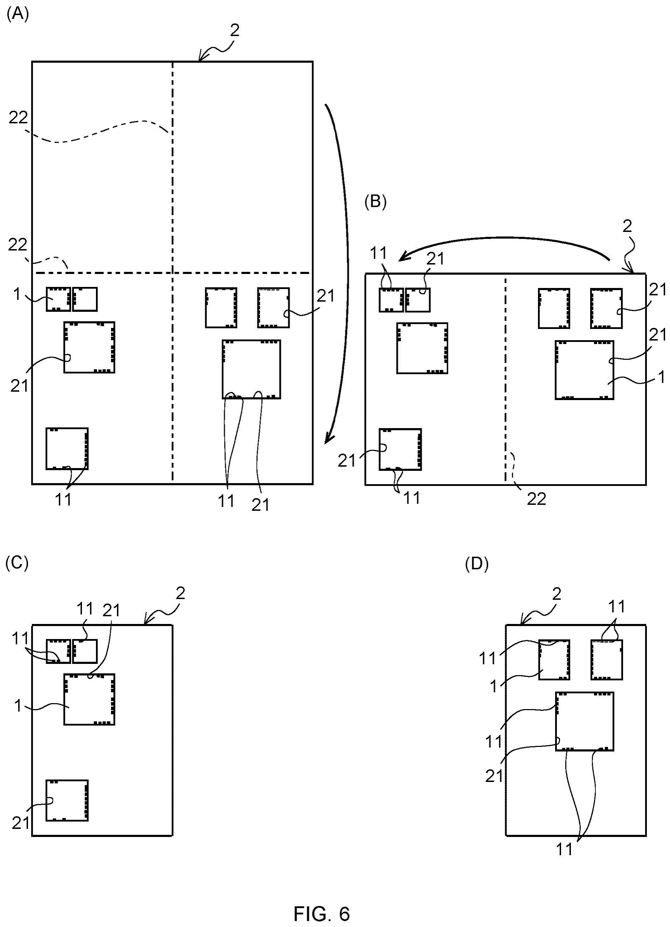

Although not limited thereto, in the folding step in this embodiment, first, a region above the folding lines 12, 22 extending in a transverse direction in the base material sheet 1 and the cover sheet 2 (FIG. 5 and FIG. 6(A)), which have been superposed as a result of having performed the superposing step, is folded toward the back of the drawing sheet of FIGS. 6 along the folding lines 12, 22 extending in the transverse direction. Then, the base material sheet 1 and the cover sheet 2 are brought into the state illustrated in FIG. 6(B).

Next, a region on a right side of the folding lines 12, 22 extending in a vertical direction in FIG. 6(B) in the base material sheet 1 and the cover sheet 2, which have been brought into the state illustrated in FIG. 6(B), is folded toward the back of the drawing sheet of FIGS. 6 along the folding lines 12, 22 extending in the vertical direction. Then, the base material sheet 1 and the cover sheet 2, which have been folded together by being folding, are brought into the state illustrated in FIG. 6(C). When the folded base material sheet 1 and cover sheet 2 are seen from the back of the drawing sheet of FIG. 6(C), the sheets are in the state illustrated in FIG. 6(D).

The folding step in this embodiment is finished in the above-mentioned manner. Under a state in which the folding step has been finished, four holes 21 are exposed on the side illustrated in FIG. 6(C), and three holes 21 are exposed on the side illustrated in FIG. 6(D). That is, all of the holes 21 in the cover sheet 2, namely, seven holes 21 that originally exist, are exposed to the outside under the state in which the folding step has been finished.

Further, in the example described with reference to FIGS. 6, all portions of the base material sheet 1 and the cover sheet 2 are virtually parallel to each other except for the folded portions. That is, the folded base material sheet 1 and cover sheet 2 are laminated in the order of cover sheet 2, base material sheet 1, base material sheet 1, cover sheet 2, cover sheet 2, base material sheet 1, base material sheet 1, and cover sheet 2 from the side illustrated in FIG. 6(C) to the side illustrated in FIG. 6(D).

At the straddle portion at which the wiring 11 extends astride the folding line 12, all the pieces of wiring 11 extending astride the folding line 12 has a width larger than those of the portions of the wiring 11 on both sides or front and back sides of the straddle portion in the length direction thereof. Accordingly, even when the wiring 11 is folded together with the base material sheet 1, the wiring 11 is less liable to be damaged, for example, broken.

Next, the fixing step is performed.

In the fixing step, the base material sheet 1 and the cover sheet 2 are fixed to each other after the folding step has been performed.

The fixing step is performed by heating the folded base material sheet 1 and cover sheet 2. When performing the fixing step, it is preferred to not only heat the base material sheet 1 and the cover sheet 2, but also press the folded base material sheet 1 and cover sheet 2 so as to sandwich the sheets from both the side illustrated in FIG. 6(C) and the side illustrated in FIG. 6(D). Such a method is adopted in this embodiment.

Conditions for heating and pressing the base material sheet 1 and the cover sheet 2 can be adjusted depending on thicknesses and melting points of the materials. The heating and pressing conditions described below are an example of a case in which the thermoplastic resins for forming the base material sheet 1 and the cover sheet 2 are each liquid crystal polymer, more precisely, the base material sheet 1 is made of liquid crystal polymer having a melting point of 335°C, and the cover sheet 2 is made of liquid crystal polymer having a melting point of 280°C. The reason why a thermoplastic resin that has a melting point lower than that of the liquid crystal polymer as the thermoplastic resin for forming the base material sheet 1 is selected as the thermoplastic resin for forming the cover sheet 2 is as follows. Specifically, the cover sheet 2 is allowed to be softened preferentially over the base material sheet 1 in the fixing step, and thus the liquid crystal polymer for forming the cover sheet 2, which has been softened and fluidized, can satisfactorily fill a gap between the base material sheet 1 and the cover sheet 2 adjacent to each other (in which there may be unevenness due to the wiring 11) or a gap between adjacent portions of the cover sheet 2. Thus, in the invention of the present application, the thermoplastic resins for respectively forming the base material sheet 1 and the cover sheet 2 can be selected so that the melting point of the thermoplastic resin for forming the cover sheet 2 is lower than the melting point of the thermoplastic resin for forming the base material sheet 1.

For example, heating of the base material sheet 1 and the cover sheet 2 can be performed through use of a general press apparatus.
(1) First, a temperature of the base material sheet 1 and the cover sheet 2 is increased from room temperature to a temperature at which the thermoplastic resins for forming the sheets (in particular, the thermoplastic resin for forming the cover sheet) soften slightly, for example, 150°C, and the temperature is kept for several minutes. This step is performed with the following purpose. Specifically, of the base material sheet 1 and the cover sheet 2, at least the cover sheet 2 has been softened so that the thermoplastic resin that has softened and fluidized fills the gap between the base material sheet 1 and the cover sheet 2 adjacent to each other or the gap between adjacent portions of the cover sheet 2 to some extent.
(2) Next, the temperature of the base material sheet 1 and the cover sheet 2 is increased to a temperature near a melting point of the thermoplastic resins for forming the sheets (in particular, the thermoplastic resin for forming the cover sheet), for example, 290°C, and the temperature is kept for about 30 minutes. This step is performed with the following purpose. Specifically, of the base material sheet 1 and the cover sheet 2, at least the cover sheet 2 has been further softened so that the thermoplastic resin that has softened and fluidized virtually completely fills the gap between the base material sheet 1 and the cover sheet 2 adjacent to each other or the gap between adjacent portions of the cover sheet 2.
(3) Finally, the temperature of the base material sheet 1 and the cover sheets 2 is cooled down to, for example, room temperature. Through this step, the thermoplastic resins that have virtually completely filled the gap between the base material sheet 1 and the cover sheet 2 adjacent to each other or the gap between the adjacent portions of the cover sheet 2 are cured. Thus, the gap between the base material sheet 1 and the cover sheet 2 adjacent to each other, or the gap between the adjacent portions of the cover sheet 2 is virtually filled with the thermoplastic resins, and the base material sheet 1 and the cover sheet 2 adjacent to each other, or the adjacent portions of the cover sheet 2 are secured to each other.

In performing the steps (1) to (3) described above, the base material sheet 1 and the cover sheet 2 are pressed in the press apparatus.

In this embodiment, for example, pressing is not performed for a while from the start of the step (1) described above, and during a stage from about the middle of the time period in which the temperature of the base material sheet 1 and the cover sheet 2 is kept at 150°C to the end of the same step, the base material sheet 1 and the cover sheet 2 are pressed at a pressure of, for example, 3 MPa while the pressure is kept constant. The foregoing is performed in order to allow the fluidized thermoplastic resins to satisfactorily fill the gap between the base material sheet 1 and the cover sheet 2 adjacent to each other or the gap between the adjacent portions of the cover sheet 2.

Then, the base material sheet 1 and the cover sheet 2 are pressed at a constant pressure of 1 MPa from the start of the step (2) described above to the end of the step (3) described above. The reason why the applied pressure at this time is set lower than the applied pressure during the time period in which the temperature of the base material sheet 1 and the cover sheet 2 in the step (1) is kept at 150°C (in this example, this applied pressure is 3 MPa as described above) is as follows. Specifically, although it is required to apply a constant pressure in order that the fluidized thermoplastic resins satisfactorily fill the gap between the base material sheet 1 and the cover sheet 2 adjacent to each other or the gap between the adjacent portions of the cover sheets 2, when pressing is performed extremely strongly, there is a fear in that the fluidized thermoplastic resins may leak to the outside through the gap between the base material sheet 1 and the cover sheet 2 adjacent to each other or the gap between the adjacent portions of the cover sheet 2.

As described above, under the state in which the folding step has been finished, the folded base material sheet 1 and cover sheet 2 are laminated in the order of cover sheet 2, base material sheet 1, base material sheet 1, cover sheet 2, cover sheet 2, base material sheet 1, base material sheet 1, and cover sheet 2 from the side illustrated in FIG. 6(C) to the side illustrated in FIG. 6(D). Through heating, at least a part of the cover sheet 2 is molten, and is cured after the heating is finished. In this embodiment, a part of the base material sheet 1 is also molten, and is cured after the heating is finished. Accordingly, among the above-mentioned layers contained in the folded base material sheet 1 and cover sheet 2, the base material sheet 1 and the cover sheet 2 adjacent to each other, the base material sheet 1 and another base material sheet 1 adjacent to each other, the cover sheet 2 and another cover sheet 2 adjacent to each other are welded to each other.

Thus, when the fixing step is finished, the folded base material sheet 1 and cover sheet 2 are settled into a plate-like shape.

After the fixing step is finished, an electronic component mounting step is performed.

The electronic components are IC chips, BGAs, CSPs, resistors, capacitors, and the like, and are selected appropriately in accordance with the performance required for the multilayer substrate.

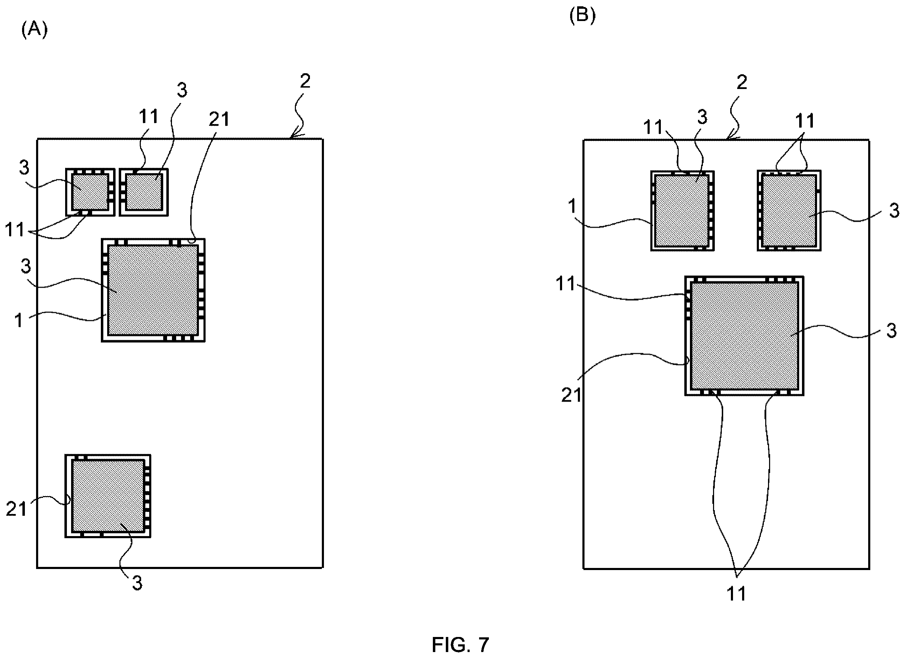

The electronic components 3 are connected in electrical continuity with the wiring 11 that is provided on the front surface of the base material sheet 1 contained in the base material sheet 1 and the cover sheet 2 that have been formed into a plate-like shape under the state in which the fixing step has been finished (FIG. 7(A) and FIG. 7(B)). Thus, the electronic components 3 are secured to the base material sheet 1.

The electronic component 3 is inserted into the hole 21 made in the cover sheet 2, and a terminal protruding from the electronic component 3 is connected in electrical continuity with the wiring 11 by, for example, being soldered to the wiring 11. It is required to insert the electronic component 3 into the hole 21 in order to secure the electronic component 3 to the wiring 11, and hence the hole 21 is required to have a size larger than that of the electronic component 3. This is because, otherwise, when the electronic component 3 is inserted into the hole 21 during mounting of the electronic component 3 to the base material sheet 1 through the hole 21, the electronic component 3 may be damaged due to pressure applied to the electronic component 3, or it may become difficult to move the electronic component 3 horizontally with respect to the front surface of the base material sheet 1. Further, in order to enable the electronic component 3 to be connected in electrical continuity with the wiring 11, the hole 21 is required to be sized and shaped so that an end portion of the wiring 11 can be seen from a peripheral edge portion of the hole 21. Thus, the hole 21 in this embodiment has such size and shape.

The holes 21 that are adjacent to each other at a short distance can be combined into a single hole 21. For example, two holes 21 that are smaller than the other holes 21 and are located side by side in a right-and-left direction on the upper left side of FIG. 7(A) can be combined into one hole 21. In such a case, two electronic components 3 are mounted in one hole 21.

All the planned electronic components 3 are secured to the base material sheet 1 to form an electric circuit by the wiring 11 and the electronic components 3. Thus, the multilayer substrate is completed.

In the multilayer substrate manufactured in this embodiment, the base material sheet 1 and the cover sheet 2 are virtually parallel to each other except for the folded portions, and the number of plies of the base material sheet 1 and the cover sheet 2 (the number of plies in total) is the same in all portions of the multilayer substrate (eight plies in this embodiment). The multilayer substrate having such a structure has a plate-like shape.

In the multilayer substrate manufactured by the method of manufacturing a multilayer substrate, the front surface of the base material sheet 1 is covered with the cover sheet 2 except for portions in which the holes 21 are made. Thus, the wiring 11 is protected by the cover sheet 2, and hence the wiring 11 is less liable to be broken.

### <Modification Example 1>

A method of manufacturing a multilayer substrate in Modification Example 1 is almost the same as the method of manufacturing a multilayer substrate described in the embodiment.

The multilayer substrate is manufactured using the base material sheet 1, the cover sheet 2, and the electronic components 3 as materials.

The configurations of the base material sheet 1 and the cover sheet 2 are basically the same between Modification Example 1 and the embodiment described above. However, the hole 21 in a lower right portion of the cover sheet 2 illustrated in FIG. 4 is slightly smaller in Modification Example 1, and the position of the hole 21 is slightly closer to a lower left corner of the cover sheet 2.

Further, in Modification Example 1, the configuration of the wiring 11 provided on the front surface of the base material sheet 1 is modified appropriately in accordance with the change in position and size of this hole 21.

In Modification Example 1, the same superposing step as that in the case of the above-mentioned embodiment is also performed.

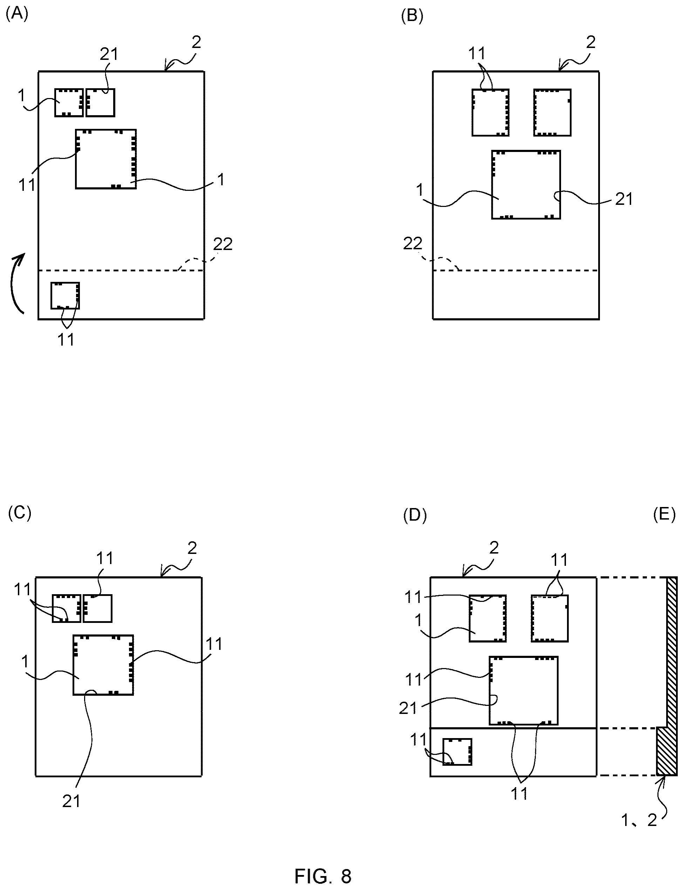

Further, in Modification Example 1, the same folding step as that in the case of the above-mentioned embodiment is performed. In the above-mentioned embodiment, the superposed base material sheet 1 and cover sheet 2 are folded twice, and also in Modification Example 1, the base material sheet 1 and the cover sheet 2 are folded twice in the same way. As a result, the base material sheet 1 and the cover sheet 2 are brought into the state illustrated in FIG. 8(A) and FIG. 8(B). FIG. 8(A) and FIG. 8(B) are views corresponding to FIG. 6(C) and FIG. 6(D).

In the folding step in Modification Example 1, the superposed base material sheet 1 and cover sheet 2 are further folded once more from this state. This third folding is performed along the folding lines 12, 22 illustrated in FIG. 8(A) and FIG. 8(B).

In the third folding, a region below the folding lines 12, 22 extending in the transverse direction in the superposed base material sheet 1 and cover sheet 2 in FIG. 8(A) is folded toward the back of the drawing sheet of FIG. 8(A) along the folding lines 12, 22 extending in the transverse direction. Then, the base material sheet 1 and the cover sheet 2 are brought into the states illustrated in FIG. 8(C) and FIG. 8(D). FIG. 8(C) and FIG. 8(D) are views for illustrating the base material sheet 1 and the cover sheet 2 as seen from the same directions as those in FIG. 8(A) and FIG. 8(B), respectively.

In this manner, the folding step in Modification Example 1 is finished.

In this case as well, after the folding step is finished, all of the seven holes 21 in the cover sheet 2 are exposed to the outside.

Further, in this case as well, after the folding step is finished, all portions of the base material sheet 1 and the cover sheet 2 are virtually parallel to each other except for the folded portions.

In addition, in the base material sheet 1 and the cover sheet 2 folded in this manner, upper portions of the folded base material sheet 1 and cover sheet 2 have eight laminated plies in the whole of the base material sheet 1 and cover sheet 2, and lower portions of the folded base material sheet 1 and cover sheet 2 have 16 laminated plies in the whole of the base material sheet 1 and cover sheet 2. As a result, in Modification Example 1, after the folding step is finished, the base material sheet 1 and the cover sheet 2 have a level difference as illustrated in FIG. 8(E), in other words, have a stair-like cross section.

After that, the fixing step and the electronic component mounting step are also performed in Modification Example 1 in the same manner as that in the above-mentioned embodiment. Thus, the multilayer substrate is completed.

The completed multilayer substrate is as illustrated in FIG. 8(C), FIG. 8(D), and FIG. 8(E) except that the electronic components 3 are mounted. As a result, the multilayer substrate manufactured by the manufacturing method in Modification Example 1 has a level difference as illustrated in FIG. 8(E), in other words, has a stair-like cross section.

### <Modification Example 2>

A method of manufacturing a multilayer substrate in Modification Example 2 is almost the same as the method of manufacturing a multilayer substrate described in the embodiment.

The multilayer substrate is manufactured using the base material sheet 1, the cover sheet 2, and the electronic components 3 as materials.

The configurations of the base material sheet 1 and the cover sheet 2 are basically the same between Modification Example 2 and the embodiment described above. However, in Modification Example 2, the base material sheet 1 and the cover sheet 2 each have a square shape.

On the front surface of the base material sheet 1 in Modification Example 2, although the entirety of the wiring is not illustrated again, the same wiring 11 as that in the case of the above-mentioned embodiment is provided.

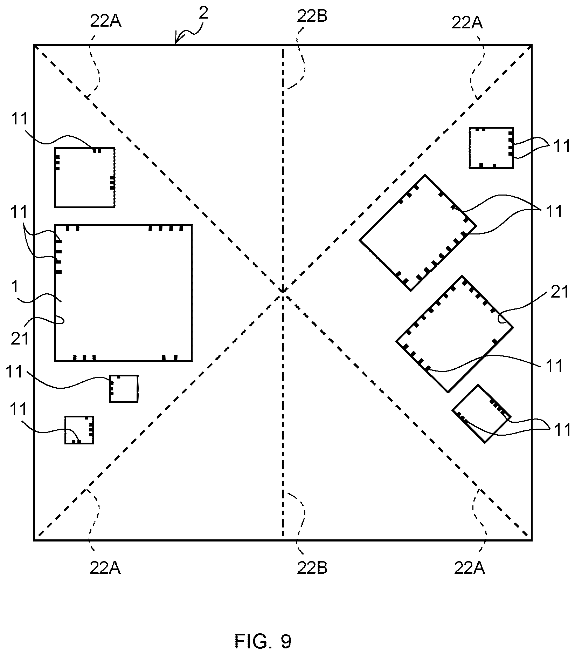

In Modification Example 2, the same superposing step as that in the case of the above-mentioned embodiment is also performed (FIG. 9). The cover sheet 2 has the holes 21 made therein in the same manner as that in the case of the above-mentioned embodiment. The number of the holes 21 is eight in Modification Example 2, though not limited thereto.

Further, in Modification Example 2, the folding step is also performed after the superposing step in the same manner as that in the case of the above-mentioned embodiment. The dashed lines 22A illustrated in FIG. 9 are mountain-folding lines along which the base material sheet 1 and the cover sheet 2 are mountain-folded, and the chain double-dashed line 22B is a valley-folding line along which the base material sheet 1 and the cover sheet 2 are valley-folded.

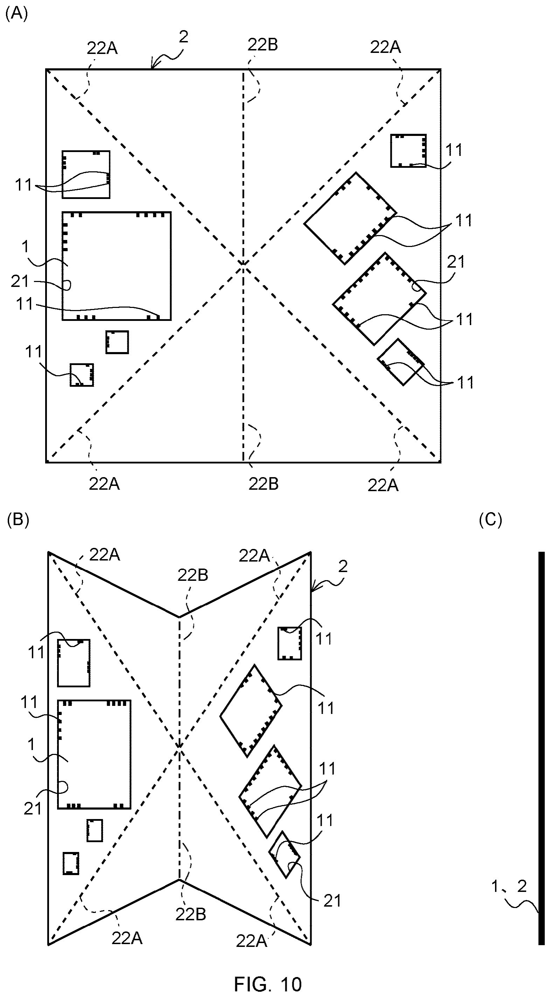

In this embodiment, the base material sheet 1 and the cover sheet 2 are simultaneously mountain-folded along the mountain-folding lines 22A and valley-folded along the valley-folding line 22B, and thus are folded from the state illustrated in FIG. 10(A), through the state illustrated in FIG. 10(B), to the plate-like state illustrated in FIG. 10(C). This type of folding is a common folding method of origami. In FIG. 10(B), centers of the base material sheet 1 and the cover sheet 2 are located on the front side of the drawing sheet of FIG. 10(B), and edges of the base material sheet 1 and the cover sheet 2 are located on the deep side of the drawing sheet of FIG. 10(B).

In this manner, the folding step in Modification Example 2 is finished.

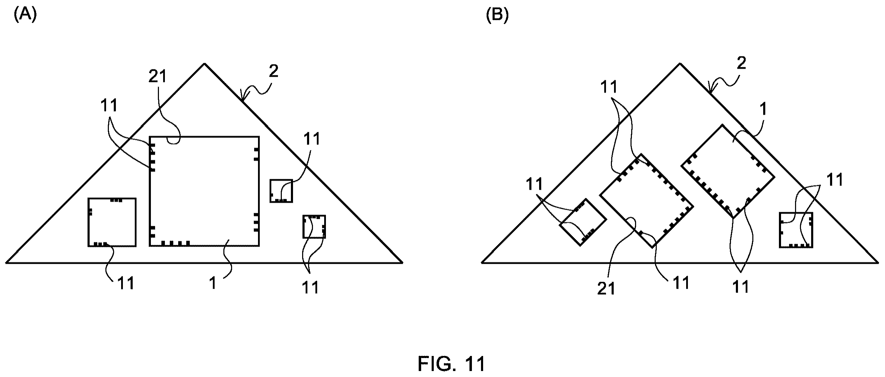

In this case as well, after the folding step is finished, all of the eight holes 21 in the cover sheet 2 are exposed to the outside (FIGS. 11). FIG. 11(A) is a view for illustrating one surface of the base material sheet 1 and the cover sheet 2 in Modification Example 2, which have been formed into a plate-like shape after the folding step has been finished, and FIG. 11(B) is a view for illustrating another surface thereof.

Further, in this case as well, after the folding step is finished, all portions of the base material sheet 1 and the cover sheet 2 are virtually parallel to each other except for the folded portions.

After that, the fixing step and the electronic component mounting step are also performed in Modification Example 2 in the same manner as that in the above-mentioned embodiment. Thus, the multilayer substrate is completed.

The completed multilayer substrate is as illustrated in FIG. 10(C) and FIGS. 11 except that the electronic components 3 are mounted. As a result, the multilayer substrate manufactured by the manufacturing method in Modification Example 2 has a right-angled isosceles triangular plate-like shape with the electronic components 3 mounted on both the front and back surfaces.

### <Modification Example 3>

A method of manufacturing a multilayer substrate in Modification Example 3 is different from that in Modification Example 2 in a way of folding the base material sheet 1 and the cover sheet 2 in the folding step, but is the same as that in Modification Example 2 except for the folding way.

The multilayer substrate is manufactured using the base material sheet 1, the cover sheet 2, and the electronic components 3 as materials.

The configurations of the base material sheet 1 and the cover sheet 2 are basically the same between Modification Example 3 and Modification Example 2. Also in Modification Example 3, the base material sheet 1 and the cover sheet 2 each have a square shape.

On the front surface of the base material sheet 1 in Modification Example 3, although the entirety of the wiring is not illustrated again, the same wiring 11 as that in the case of the above-mentioned embodiment is provided.

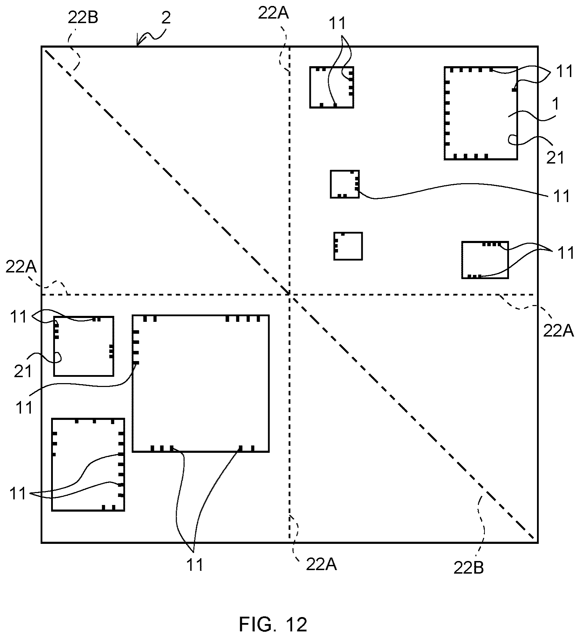

In Modification Example 3, the same superposing step as that in the case of Modification Example 2 is also performed (FIG. 12). The cover sheet 2 has the holes 21 made therein in the same manner as that in the case of the above-mentioned embodiment. The number of the holes 21 is eight in Modification Example 3, though not limited thereto.

Further, in Modification Example 3, the folding step is also performed after the superposing step in the same manner as that in the case of the above-mentioned embodiment. The dashed lines 22A illustrated in FIG. 12 are mountain-folding lines along which the base material sheet 1 and the cover sheet 2 are mountain-folded, and the chain double-dashed line 22B is a valley-folding line along which the base material sheet 1 and the cover sheet 2 are valley-folded.

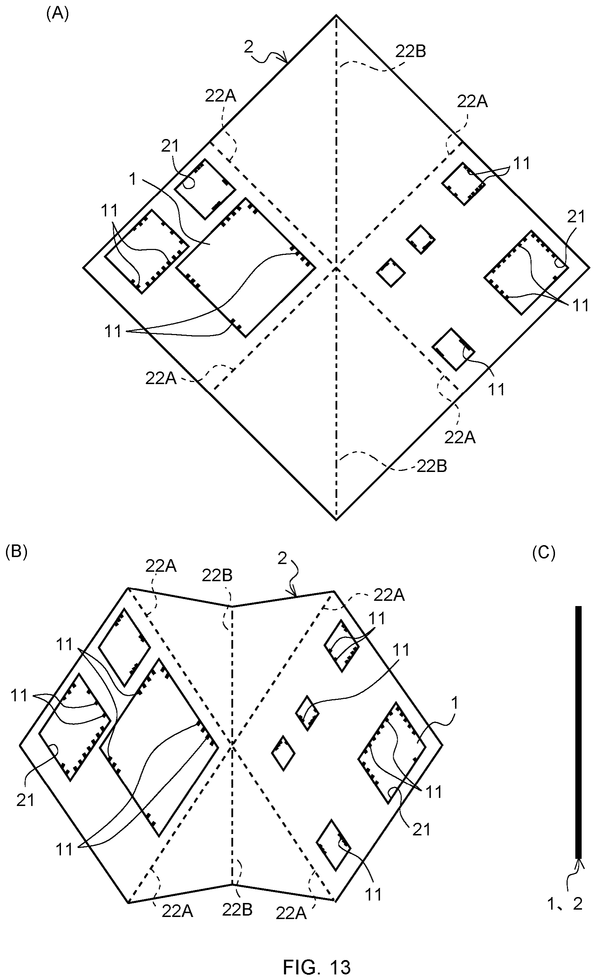

In this embodiment, the base material sheet 1 and the cover sheet 2 are simultaneously mountain-folded along the mountain-folding lines 22A and valley-folded along the valley-folding line 22B, and thus are folded from the state illustrated in FIG. 13(A), through the state illustrated in FIG. 13(B), to the plate-like state illustrated in FIG. 13(C). This type of folding is a common folding method of origami. In FIG. 13(B), centers of the base material sheet 1 and the cover sheet 2 are located on the front side of the drawing sheet of FIG. 13(B), and edges of the base material sheet 1 and the cover sheet 2 are located on the deep side of the drawing sheet of FIG. 13(B).

In this manner, the folding step in Modification Example 3 is finished.

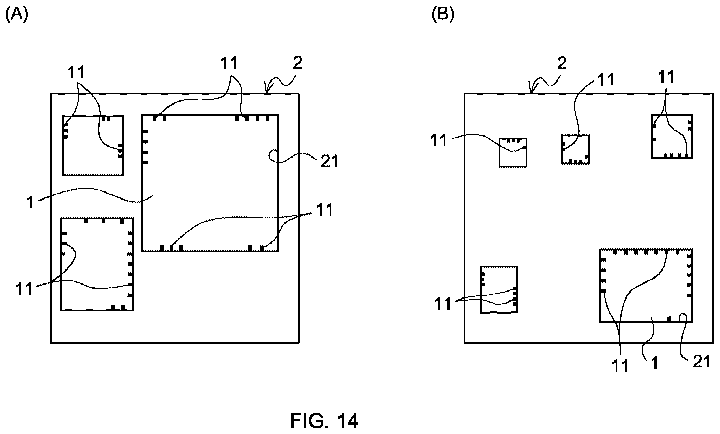

In this case as well, after the folding step is finished, all of the eight holes 21 in the cover sheet 2 are exposed to the outside (FIGS. 14). FIG. 14(A) is a view for illustrating one surface of the base material sheet 1 and the cover sheet 2 in Modification Example 3, which have been formed into a plate-like shape after the folding step has been finished, and FIG. 14(B) is a view for illustrating another surface thereof.

Further, in this case as well, after the folding step is finished, all portions of the base material sheet 1 and the cover sheet 2 are virtually parallel to each other except for the folded portions.

After that, the fixing step and the electronic component mounting step are also performed in Modification Example 3 in the same manner as that in the above-mentioned embodiment. Thus, the multilayer substrate is completed.

The completed multilayer substrate is as illustrated in FIG. 13(C) and FIGS. 14 except that the electronic components 3 are mounted. As a result, the multilayer substrate manufactured by the manufacturing method in Modification Example 3 has a plate-like square shape with the electronic components 3 mounted on both the front and back surfaces.

### <Modification Example 4>

A method of manufacturing a multilayer substrate in Modification Example 4 is different from that in Modification Example 2 in a way of folding the base material sheet 1 and the cover sheet 2 in the folding step, and in a way of performing the fixing step, but is the same as that in Modification Example 2 except for the folding way and the performing way.

The multilayer substrate is manufactured using the base material sheet 1, the cover sheet 2, and the electronic components 3 as materials.

The configurations of the base material sheet 1 and the cover sheet 2 are basically the same between Modification Example 4 and Modification Example 2. However, also in Modification Example 4, the base material sheet 1 and the cover sheet 2 each have a square shape.

On the front surface of the base material sheet 1 in Modification Example 4, although the entirety of the wiring is not illustrated again, the same wiring 11 as that in the case of the above-mentioned embodiment is provided.

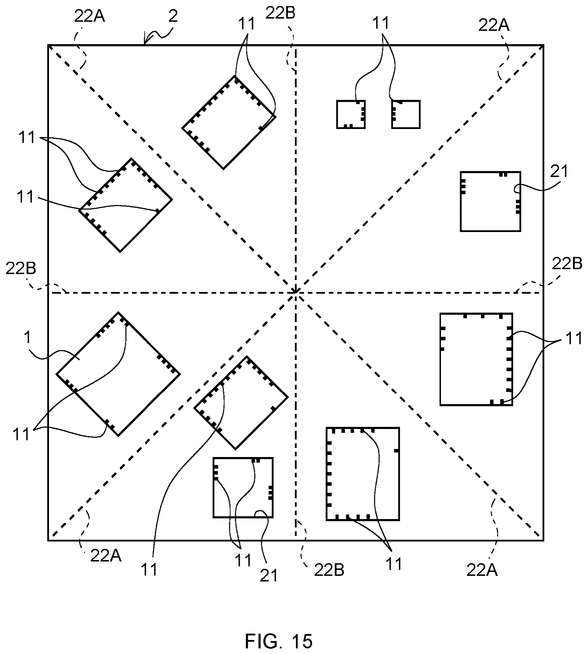

In Modification Example 4, the same superposing step as that in the case of Modification Example 2 is also performed (FIG. 15). The cover sheet 2 has the holes 21 made therein in the same manner as that in the case of the above-mentioned embodiment. The number of the holes 21 is 10 in Modification Example 4, though not limited thereto.

Further, in Modification Example 4, the folding step is also performed after the superposing step in the same manner as that in the case of the above-mentioned embodiment. The dashed lines 22A illustrated in FIG. 15 are mountain-folding lines along which the base material sheet 1 and the cover sheet 2 are mountain-folded, and the chain double-dashed lines 22B are valley-folding lines along which the base material sheet 1 and the cover sheet 2 are valley-folded.

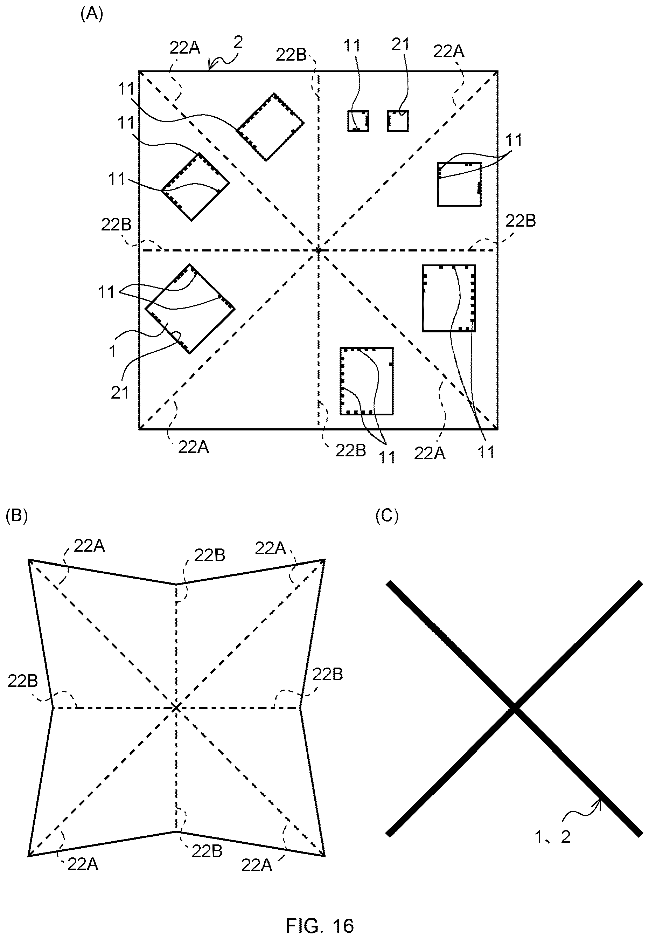

In this embodiment, the base material sheet 1 and the cover sheet 2 are simultaneously mountain-folded along the mountain-folding lines 22A and valley-folded along the valley-folding lines 22B, and thus are folded from the state illustrated in FIG. 16(A), through the state illustrated in FIG. 16(B), to the plate-like state illustrated in FIG. 16(C). This type of folding is a common folding method of origami. In FIG. 16(B), centers of the base material sheet 1 and the cover sheet 2 are located on the front side of the drawing sheet of FIG. 16(B), and edges of the base material sheet 1 and the cover sheet 2 are located on the deep side of the drawing sheet of FIG. 16(B). Further, in FIG. 16(B), there are omitted illustration of the holes 21 in the cover sheet 2, and illustration of the wiring 11 in the base material sheet 1, which can be seen through the holes 21.

In this manner, the folding step in Modification Example 4 is finished.

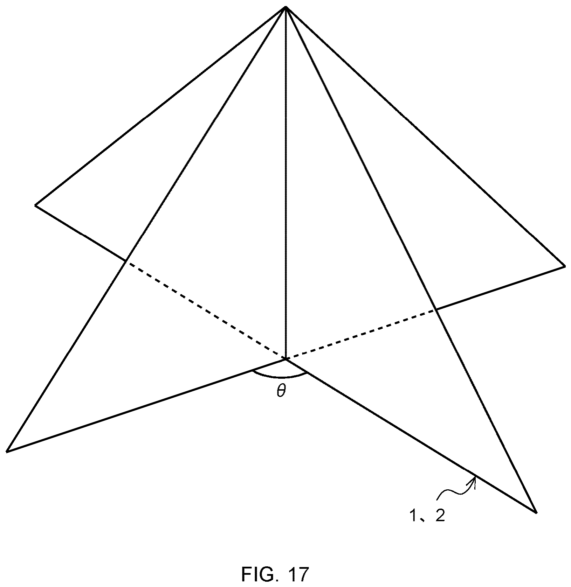

In the case of Modification Example 4, after the folding step is finished, the base material sheet 1 and the cover sheet 2 have such a shape that, when seen in plan view, right-angled isosceles triangular plates of the same size extend in four symmetrical directions, and are connected together so that sides of the isosceles triangles that are not hypotenuses overlap each other (see FIG. 16(C) and FIG. 17).

In this case as well, after the folding step is finished, all of 10 holes 21 in the cover sheet 2 are exposed to the outside. This is because each of the 10 holes 21 is located in any one of both surfaces of four right-angled isosceles triangular plate-like portions described above after the folding step is finished. FIG. 17 is a perspective view for illustrating the base material sheet 1 and the cover sheet 2 in Modification Example 4 after the folding step is finished.

In Modification Example 4, after the folding step is finished, portions of the base material sheet 1 and the cover sheet 2 are non-parallel to other portions of the base material sheet 1 and the cover sheet 2. Thus, in Modification Example 4, after the folding step is finished, the base material sheet 1 and the cover sheet 2 have a three-dimensional shape.

After that, the fixing step and the electronic component mounting step are also performed in Modification Example 4 in the same manner as that in the above-mentioned embodiment. Thus, the multilayer substrate is completed.

However, in this embodiment, the fixing step is performed four times separately and respectively for the right-angled isosceles triangular plate-like portions described above. Each right-angled isosceles triangular plate-like portion is heated while pressure is applied thereto. In this manner, in each of the four plate-like portions, the base material sheet 1 and the cover sheet 2, which are held in abutment against each other, and portions of the base material sheet 1, which are held in abutment against each other, are secured to each other.

The completed multilayer substrate is as illustrated in FIG. 16(C) and FIG. 17 except that the electronic components 3 are mounted. As a result, the multilayer substrate manufactured by the manufacturing method in Modification Example 4 has a three-dimensional configuration as described above.

An angle (θ in FIG. 17) formed between the adjacent right-angled isosceles triangular plate-like portions when seen in plan view is basically 90 degrees. However, this angle is variable because the right-angled isosceles triangular plate-like portions are rotatable about the sides, which are not hypotenuses, at which the four plate-like portions overlap each other.

### Reference Signs List

- 1: base material sheet

- 2: cover sheet
- 3: electronic component
- 11: wiring
- 12: folding line
- 21: hole
- 22: folding line

## Claims

1. A method of manufacturing a multilayer substrate, comprising:
a superposing step of superposing a cover sheet on a front surface of a base material sheet under a state in which a contour of the base material sheet and a contour of the cover sheet match each other, the base material sheet being provided with conductive wiring on the front surface in appropriate arrangement, and being a rectangular sheet that is made of a thermoplastic resin and has insulating properties, the cover sheet having at least one hole formed at a position at which an electronic component is to be arranged later, and being a sheet that is made of a thermoplastic resin, has insulating properties, and has virtually the same shape and size as a shape and a size of the base material sheet;
a folding step of folding the superposed base material sheet and cover sheet so that the at least one hole is exposed to an outside;
a fixing step of fixing the base material sheet and the cover sheet adjacent to each other by heating the folded base material sheet and cover sheet to melt at least a part of the cover sheet, and then cooling and curing the base material sheet and the cover sheet; and
an electronic component mounting step of securing an electronic component, which is inserted into the at least one hole, to the base material sheet seen through the at least one hole under a state in which the electronic component is held in electrical continuity with the wiring on the front surface of the base material sheet seen through the at least one hole.

2. The method of manufacturing a multilayer substrate according to claim 1, wherein the base material sheet is square.

3. The method of manufacturing a multilayer substrate according to claim 2, wherein after the electronic component mounting step is finished, the base material sheet and the cover sheet each have a square shape or a right-angled isosceles triangular shape.

4. The method of manufacturing a multilayer substrate according to claim 1, wherein the folding step is performed so that, after the electronic component mounting step is finished, all portions of the base material sheet and the cover sheet are virtually parallel to each other except for folded portions of the base material sheet and the cover sheet.

5. The method of manufacturing a multilayer substrate according to claim 4, wherein the folding step is performed so that, after the electronic component mounting step is finished, the number of plies of the superposed base material sheet and cover sheet in a certain region other than the folded portions is different from the number of plies of the superposed base material sheet and cover sheet in another region.

6. The method of manufacturing a multilayer substrate according to claim 1, wherein, in the fixing step, among the superposed base material sheet and cover sheet, adjacent portions of the cover sheet are fixed together.

7. The method of manufacturing a multilayer substrate according to claim 1 or 5, wherein, in the fixing step, the superposed base material sheet and cover sheet are heated while pressure is applied to the base material sheet and the cover sheet.

8. The method of manufacturing a multilayer substrate according to claim 1, wherein, before the superposing step, a wiring step of providing the wiring on the front surface of the base material sheet is performed.

9. The method of manufacturing a multilayer substrate according to claim 1 or 8, wherein the wiring is provided so that a width of the wiring at a portion at which the base material sheet will be folded later is larger than a width of the wiring at portions on both sides of the folded portion in a length direction of the wiring.

10. The method of manufacturing a multilayer substrate according to claim 1 or 9, wherein a thickness of the cover sheet is smaller than a thickness of the base material sheet.
